# EUROPEAN PATENT SPECIFICATION

(11) **EP 1 436 601 B1**
(45) Date of publication and mention of the grant of the patent: **01.10.2014**
(21) Application number: 01945982.5
(22) Date of filing: 23.05.2001
(51) Int. Cl.: H01L 21/67

(54) **METHOD FOR SAMPLE SEPARATION AND LIFT-OUT**
VERFAHREN ZUR PROBENTRENNUNG UND PROBENAUSHEBUNG
PROCEDE DE SEPARATION ET DE RETRAIT D'ECHANTILLONS

(43) Date of publication of application: 14.07.2004
(73) Proprietor: Omniprobe, Inc., Dallas, TX (US)
(72) Inventor: MOORE, Thomas, M., Dallas, TX 75240 (US); KRUGER, Rocky, D., Dallas, TX 75240 (US); HARTFIELD, Cheryl, McKinney,TX 75070 (US)
(74) Representative: Lord, Michael
(86) International application number: PCT/US2001/016644
(87) International publication number: WO 2002/095378

(56) References cited:
- EP-A- 0 927 880
- EP-A- 1 209 737
- US-A- 5 270 552
- US-A- 5 350 499
- US-A- 6 039 000
- US-A- 6 080 991

## Description

### TECHNICAL FIELD OF THE INVENTION

The invention relates to methods for separating and manipulating microscopic samples from objects within electron-beam or ion-beam instruments.

### BACKGROUND OF THE INVENTION

The present invention relates to a method for separating a sample and a method for preparing the separated sample for analysis, in cases where analysis is desired; and particularly relates to a method for separating a minute sample region from a substrate such as a semiconductor wafer.

This application describes embodiments in which a sample is cut out of a semiconductor wafer or other object by use of a focused ion beam ("FIB") and analyzed, if desired, through a transmission electron microscope ("TEM"), or by other means.

In a conventional method for TEM sample preparation, a chip, or ribbon, having a length of several mm and a width of 100-500 µm is cut out from a semiconductor integrated circuit wafer by use of a diamond wafering saw. The chip is mounted on a standard TEM grid. Then the chip is formed into a thin sample (typically 50 µm) by the FIB. The thin film sample is irradiated with an electron beam and observed by use of the TEM.

In conventional TEM observations a sample is thinned by polishing, while being observed. With this method, it is difficult to set the place of observation and direction of the sample desirably and precisely. It is necessary to carry out a step in which a region having a length of several mm and a width of 100-500 µm, and including a portion to be analyzed, is mechanically separated from the chip of an integrated circuit or semiconductor wafer. When a wafer is a sample substrate, it is necessary to divide the wafer for observation. It is difficult to process a sample to have a thickness less than 100 µm through mechanical processing by means of a diamond wafering saw or the like, because it is difficult to maintain accuracy and avoid damage. Portions which could not be cut to be thin enough through mechanical processing, would then have to be thinned with the FIB, which adds to processing time.

In another conventional method, the sample is cleaved first. The plane of cleavage is then observed by a scanning-electron microscope. This method however, makes it difficult to specify a desired portion precisely, and makes it difficult to observe the section cleaved. All of the foregoing conventional techniques have disadvantages because it is difficult to make a section even substantially flat and parallel to the sample surface for observation, and it is impossible to observe, for example, a horizontal section of a contact hole.

Another conventional method uses the FIB to cut a sample from a wafer by cutting the sample from at least two different angles after a probe has been attached to the sample. The probe then removes the sample for analysis. This method has the disadvantage that the wafer must be moved to a second angle for the second cut to be effected. These techniques typically rely on a break in electrical conductivity or trial and error to tell when the sample is isolated.

EP-A-1 209 737 published on May 25, 2002 is considered to be comprised in the state of the art relevant to the question of novelty, pursuant to Article 54(3) and (4) EPC 1973. This document discloses a method for sample separation and lift-out comprising the steps of : a. positioning a wafer, the wafer having a target, inside a FIB instrument, for inspection of the target; b. fixing the tip of a probe to the wafer; c. positioning an ion beam at an angle less than 90 degrees to plane of the wafer; d. cutting with the ion beam positioned at the angle defined a sample of the waver enclosing the target and the fixed probe, so that the sample is completely released from the wafer; e. moving the probe with the sample fixed to it to a holder for inspection; f. fixing the sample to the holder; and; g. detaching the probe from the sample.

In EP-A-0 927 880 there is described a method for sample separation and lift-out according to the preamble of claim 1.

It is against this background, and the limitations and problems associated therewith, that the present invention has been developed.

Therefore, it is primary objective to the present invention to provide a method of sample separation which can produce precise samples, but which does not need multiple cuts. There is a particular need for a sample-separation method which will allow the operator to see the operation in process and to clearly see when the sample separates, without the need for electrical contact tests, or the like.

To achieve this, the method of the invention is characterized by the features claimed in the characterizing part of claim 1.

### SUMMARY OF THE INVENTION

The invention is a method for sample separation and lift-out within a FIB instrument. The invention comprises the steps of, first, cleaving a wafer, having an area of interest, or target, to be removed, so as to place the target near the edge of the cleaved wafer.

Then, the tip of a micromanipulator probe is fixed to the wafer by ion-beam metal deposition. The FIB ion-beam is positioned at an angle of approximately 50 degrees to the plane of the wafer, and the ion beam cuts a U-shaped path on the surface of the wafer, so that the path surrounds the target and the fixed probe, and completely released the sample from the wafer. Next, the stage of the FIB is lowered slightly, so that the wafer is lowered beneath the released sample, now attached to the probe.

The probe with the sample fixed to it is moved to a TEM grid. The TEM grid is preferably cut across its plane so as to provide a V-shape open above. The opening allows easy access to the V-shape for placement of the sample and further operations with the ion beam. The sample is then fixed to the TEM grid by ion-beam metal deposition, and the probe is then cut by the ion-beam and detached from the fixed sample. The sample may now be thinned by the ion beam for TEM inspection, or inspected by other means. The reader should note that with the method just described, only one ion-beam cut at one angle is necessary to release the sample from the wafer and allow it to be lifted out.

### BRIEF DESCRIPTION OF THE DRAWINGS

Figure 1 is a typical wafer with an area of interest shown. The wafer is cut to create an edge near the area of interest.
Figure 2 shows the attachment of a probe to the wafer.
Figure 3 shows the FIB cutting out a sample bearing the area of interest, or target.
Figure 4 shows removal of the sample from the wafer.
Figures 5, 6, 7, and 8 show the attachment of the sample to a TEM grid, and detachment of the probe.

### DETAILED DESCRIPTION OF THE PREFERRED EMBODIMENTS

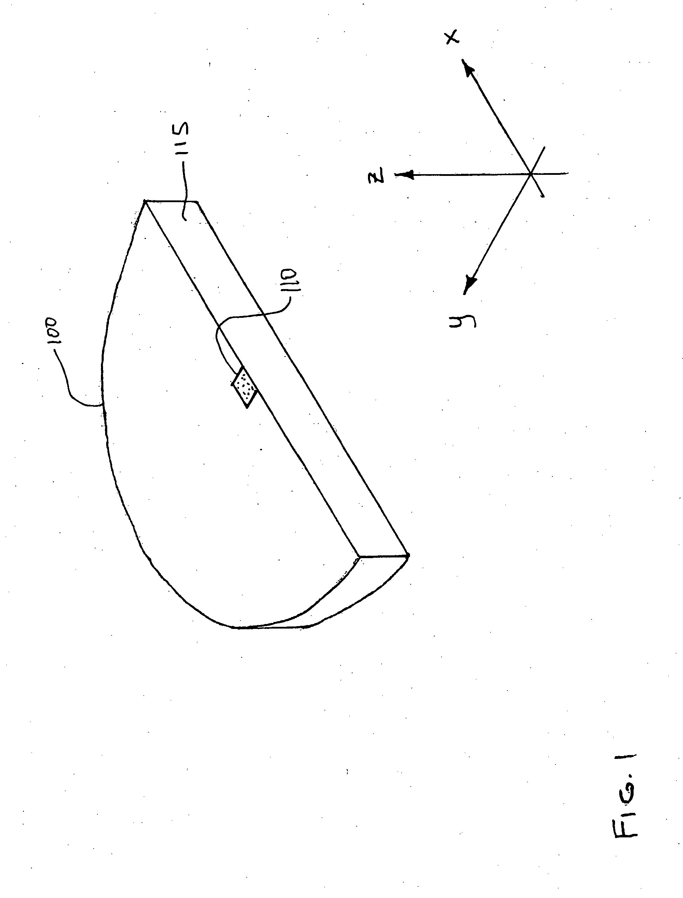

Figure 1 shows a semiconductor wafer (100) which has been cleaved or sawed so the area of interest or "target" (110) for lift-out is located as close as possible to newly formed edge (115). "Cleaving" may be done by sawing The further from the edge, the longer (in y direction) and the deeper (in z direction), is the cut required to remove the sample. A longer and deeper cut will significantly add time to the operation. The operator inserts the wafer in FIB. In this application, we describe the object under examination as a "wafer." The "wafer" (100) need not be a semiconductor device. It may, for example be a micromechanical device, or any substance whatever requiring TEM or SEM analysis, such as particles, granules, biological materials, or thin films. The FIB may be either a single-beam model, or a dual-beam model. Typical FIB instruments are those manufactured by FEI Company of Hillsboro, Oregon, as models 200, 820, 830, or 835.

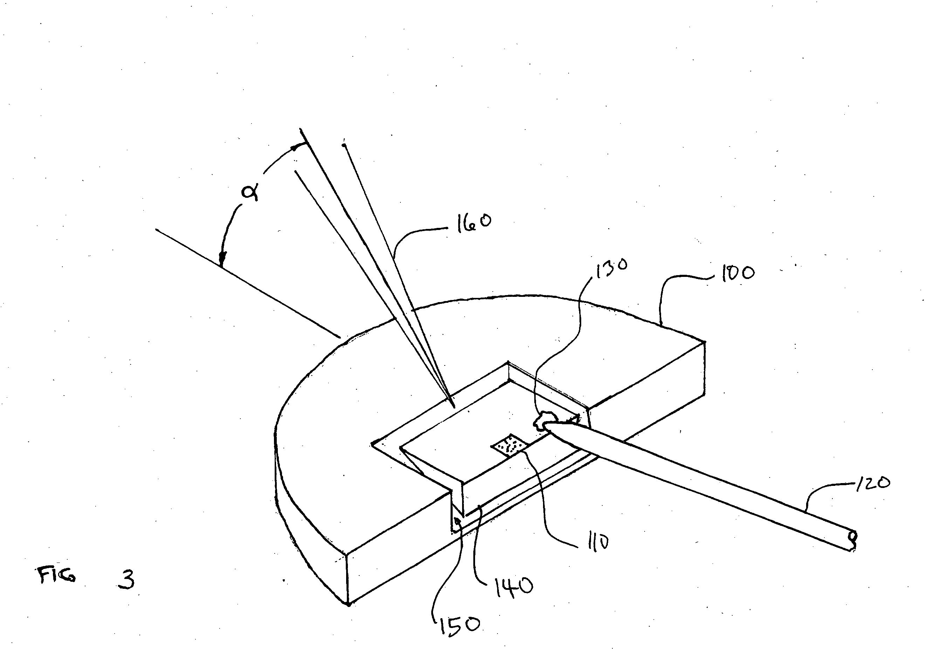

After the cleaved wafer (100) is placed in the FIB instrument, the eucentric position of the ion beam (160) should be set on the target (110). The sample should rest at an angle α depicted in Figure 3 to the ion beam (160). The angle α can be any angle less than ninety degrees to the plane of the wafer (100), although an angle of 45-60 degrees is preferable. Typically, the wafer (100) will be perpendicular to the electron beam, if the FIB has an electron beam in addition to the ion beam (160).

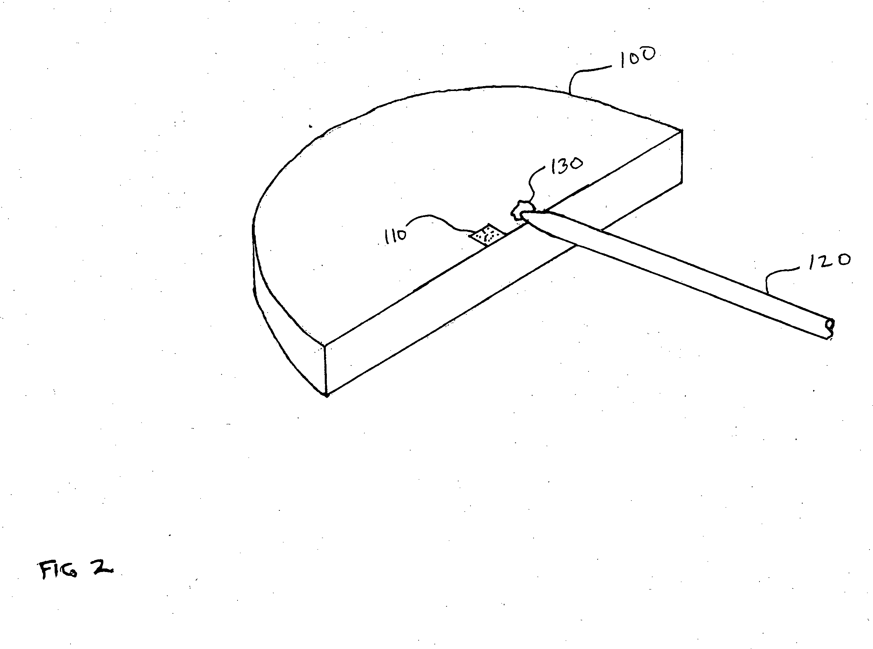

Figure 2 shows a probe (120) that has made contact with the wafer (100) near the target (110). The probe (120) is a component of a conventional micro-manipulator tool which is attached to the FIB instrument with vacuum feed-through. A typical such micro-manipulator tool is the Model 100 by Omniprobe, Inc. of Dallas, Texas. The probe (120) is moved until its tip makes physical contact with the wafer (100), as shown in Figure 2. The operator then preferably uses ion-beam metal deposition to form a weld (130) that fixes the tip of the probe (120) to the wafer (100). Other methods may be used to fix the probe (120) to the wafer (100), such as electrostatic attraction or adhesives.

Next, the operator uses the layout functions of the FIB instrument to specify a pattern on the wafer (100) surrounding the target (110), and preferably extending to the edge (115) of the wafer (100) in the y-direction, as shown in Figure 3. The pattern is preferably U-shaped around the target (110), although a rectangular area, or an arbitrary shape enclosing the target (110) could also be used. This area defines the sample area to be milled by the ion-beam (160). The milling cut (150) should be as thick as necessary to prevent redeposited material from filling the cut. This will depend on the properties of the wafer (100). The specified pattern is milled to completely cut out the sample (140). Gas-assisted etching may also be used, if desired. This operation is illustrated in Figure 3.

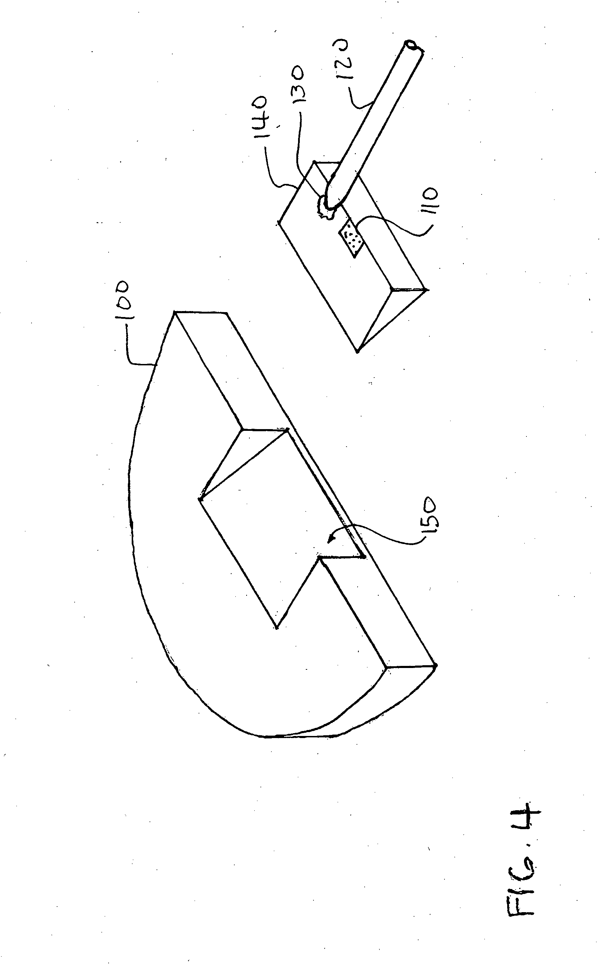

By viewing the image as the operation proceeds, it will be possible to see when the sample (140) is completely detached. After the sample (140) is completely cut from the wafer (100), the operator will increase the distance between the probe (120) (now holding the sample (140) and target (110)), and the remaining wafer (100), preferably by lowering the FIB stage height by at least 5-10 µm to drop the wafer (100). The operator withdraws the probe (120) holding the target (110) so the sample (140) will be clear of any obstacles when the wafer (100) is exchanged for the TEM grid (200). This operation is shown in Figure 4. Of course, the sample holder need not be a TEM grid (200) as shown, but may be another type of holder or device suitable for the intended inspection.

When the probe (120) and the sample (140) are completely clear of any potential obstruction, the operator removes the wafer (100) to exchange it for the TEM grid (200) holder. Separation of the cut sample (140) from the wafer (100) is preferably assisted by slightly lowering the wafer (100); typically by lowering the stage in the FIB instrument.

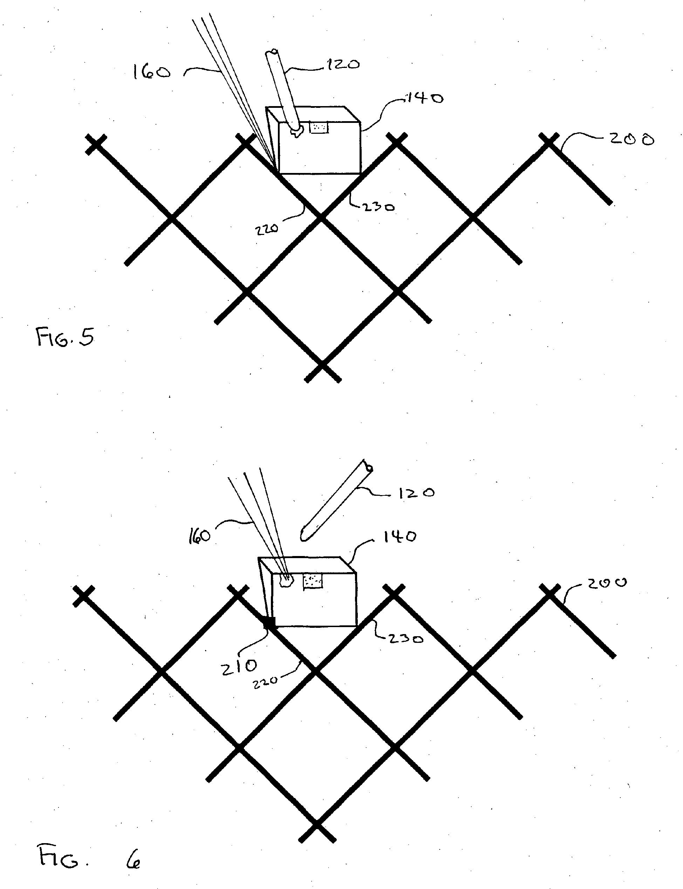

The TEM grid (200) is a standard grid, such as an uncoated 100 or 200 square mesh Cu grid. For the purposes of the method disclosed, the TEM grid (200) is cut across so that the cut bars form "V's" open above (in the z-axis) (see Figure 5). Using the probe (120) the TEM grid (200) is mounted in the FIB with the cut side up, or with its plane parallel to the z-axis. When the TEM grid (200) is inserted into the FIB, the eucentric position should be set on the cut edge of the TEM grid (200).

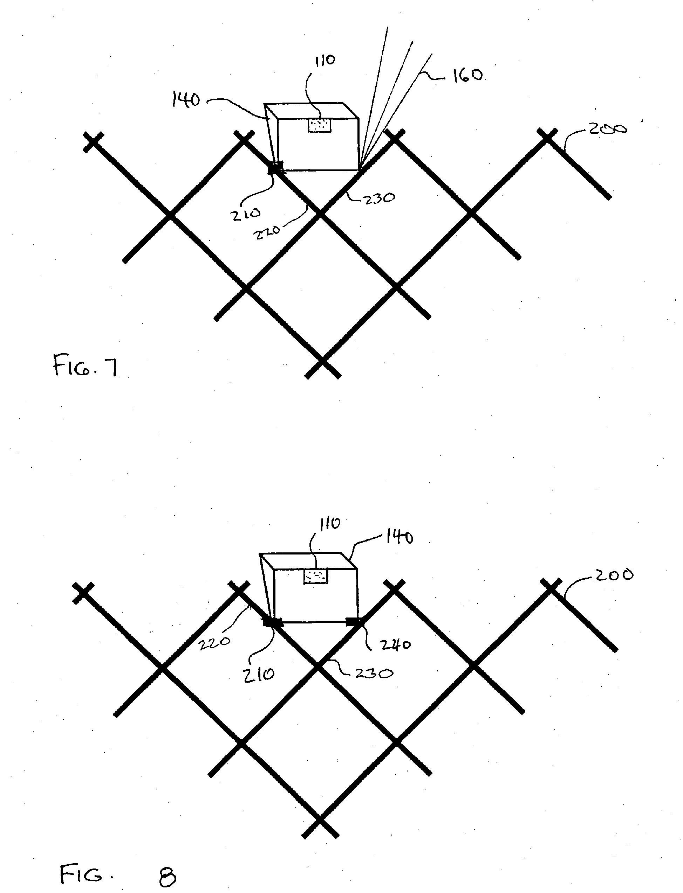

The operator then moves the probe (120) with the sample (140) attached as shown in Figure 5. The probe (120) is moved until both ends of the sample (140) contact the bars of the TEM grid (200) as shown in Figure 5 and the following figures. Using FIB metal deposition, the operator welds a free edge of the sample (140) to a first bar (220) of the TEM grid (200) forming a first weld (210). The operator should choose an edge which will allow the ion beam (160) to contact the location of the first weld (210) without interference of the probe (120). Figure 6 shows the probe (120) detached from the sample weld (130) by use of the ion beam (160). The probe (120) may now be retracted. The operator then uses FIB metal deposition to weld the newly freed edge of sample (140) to a second bar (230) of the TEM grid (200), forming a second weld (240), as shown in Figures 7 and 8. The sample can now be thinned by the FIB to a thickness suitable for the TEM application.

## Claims

1. A method for sample separation and lift-out comprising the steps of:
a. positioning a wafer (100), the wafer (100) having a target (110), inside a FIB instrument, for inspection of the target (110),
b. fixing the tip of a probe (120) to the wafer (100),
c. positioning an ion beam (160) at an angle (α) less than 90 degrees to plane of the wafer (100),
d. cutting (150) with the ion beam (160) positioned at said angle (α), a sample (140) of the wafer (100) enclosing the target (110) and the fixed probe (120), so that the sample (140) is completely released from the wafer (100),
e. moving the probe (120) with the sample (140) fixed to it to a holder (200) for inspection,
f. fixing the sample (140) to the holder (200), and,
g. detaching the probe (120) from the sample (140),
**characterized in that** the wafer (100) is first cleaved so as to place the target (110) near the edge (115) of the cleaved wafer (100).

2. The method for sample separation and lift-out of claim 1, **characterized in that** the probe tip is fixed to the wafer (100) with ion-beam metal deposition (130).

3. The method for sample separation and lift-out of claim 1, **characterized in that** the probe tip is fixed to the wafer (100) by electrostatic attraction.

4. The method of sample separation and lift-out of claim 1, **characterized in that** the probe tip is fixed to the wafer (100) with adhesive.

5. The method for sample separation and lift-out of claim 1, **characterized in that** the angle (α) of the ion beam (160) with respect to the plane of the wafer (100) is approximately 50 degrees.

6. The method for sample separation and lift-out of claim 1, **characterized in that** the cutting of the ion beam (160) follows a rectangular path on the surface of the wafer (100), the path surrounding the target (110) and the fixed probe (120).

7. The method for sample separation and lift-out of claim 1, **characterized in that** the cutting of the ion beam (160) follows a U-shaped path on the surface of the wafer (100), the path surrounding the target (110) and the fixed probe (120).

8. The method for sample separation and lift-out of claim 1, **characterized in that** the release of the sample (160) from the wafer (100) is assisted by first lowering the wafer (100).

9. The method of sample separation and lift-out of claim 1, **characterized in that** the holder is a TEM grid (200).

10. The method of sample separation and lift-out of claim 1, **characterized in that** the probe (120) is fixed to the holder (200) by ion-beam metal deposition (210, 230).

11. The method for sample separation and lift-out of claim 1, **characterized in that** the probe (120) is detached from the sample (140) by cutting with the ion beam (160).

12. The method for sample separation and lift-out of claim 1, **characterized in that** the wafer (100) is a semiconductor device.

13. The method of sample separation and lift-out of claim 1, **characterized in that** the wafer (100) is a micromechanical device.

14. The method for sample separation and lift-out of claim 1, **characterized in that** the effects of the ion beam (160) are assisted by gas-assisted etching.

15. The method for sample separation and lift-out of claim 1, **characterized in that** the tip of the probe (120) is fixed to the wafer (100) by ion-beam metal deposition,
the ion-beam (160) is positioned at an angle of approximately 50 degrees to the plane of the wafer (100), and by the steps of
cutting with the ion-beam (160) a U-shaped path on the surface of the wafer (100), the path surrounding the target (110) and the fixed probe (120), so that the sample (140) is completely released from the wafer (100),
lowering the wafer (100) slightly,
moving the probe (120) with the sample (140) fixed to it to a TEM (200) grid, the TEM (200) grid having a cut across it to provide a V-shape open above,
fixing the sample (140) to the TEM grid (200) by ion-beam metal deposition, and,
detaching the probe (120) from the sample (140) by cutting with the ion beam (160).

## Patentansprüche

1. Verfahren zur Trennung und zum Lift-out von Proben, umfassend die Schritte von:
a. Positionierung eines Wafers (100), wobei der Wafer (100) ein Target (110) aufweist, im Inneren eines FIB-Instruments, zur Inspektion des Targets (110),
b. Befestigen der Spitze einer Sonde (120) am Wafer (100),
c. Positionierung eines Ionenstrahls (160) in einem Winkel (α) kleiner als 90 Grad zur Ebene des Wafers (100),
d. Schneiden (150) einer Probe (140) von dem Wafer (100), der das Target (110) und die befestigte Sonde (120) einschließt, mit dem im Winkel (α) positionierten Ionenstrahl (160), so dass die Probe (140) vollkommen aus dem Wafer (100) freigegeben wird,
e. Bewegen der Sonde (120) mit der an ihr befestigten Probe (140) an einen Halter (200) zur Inspektion,
f. Befestigen der Probe (140) am Halter (200), und,
g. Lösen der Sonde (120) von der Probe (140),
**dadurch gekennzeichnet, dass** der Wafer (100) zuerst gespalten wird, um das Target (110) in die Nähe der Kante (115) des gespaltenen Wafers (100) zu bringen.

2. Verfahren zur Trennung und zum Lift-out von Proben nach Anspruch 1, **dadurch gekennzeichnet, dass** die Sondenspitze durch Metallabscheidung mittels Ionenstrahl (130) am Wafer (100) befestigt ist.

3. Verfahren zur Trennung und zum Lift-out von Proben nach Anspruch 1, **dadurch gekennzeichnet, dass** die Sondenspitze durch elektrostatische Anziehung am Wafer (100) befestigt ist.

4. Verfahren zur Trennung und zum Lift-out von Proben nach Anspruch 1, **dadurch gekennzeichnet, dass** die Sondenspitze mit Klebstoff am Wafer (100) befestigt ist.

5. Verfahren zur Trennung und zum Lift-out von Proben nach Anspruch 1, **dadurch gekennzeichnet, dass** der Winkel (α) des Ionenstrahls (160) relativ zur Ebene des Wafers (100) ca. 50 Grad beträgt.

6. Verfahren zur Trennung und zum Lift-out von Proben nach Anspruch 1, **dadurch gekennzeichnet, dass** das Schneiden mittels Ionenstrahl (160) einem rechtwinkligen Pfad auf der Oberfläche des Wafers (100) folgt, wobei der Pfad das Target (110) und die befestigte Sonde (120) umgibt.

7. Verfahren zur Trennung und zum Lift-out von Proben nach Anspruch 1, **dadurch gekennzeichnet, dass** das Schneiden mittels Ionenstrahl (160) einem U-förmigen Pfad auf der Oberfläche des Wafers (100) folgt, wobei der Pfad das Target (110) und die befestigte Sonde (120) umgibt.

8. Verfahren zur Trennung und zum Lift-out von Proben nach Anspruch 1, **dadurch gekennzeichnet, dass** die Freigabe der Probe (160) aus dem Wafer (100) unterstützt wird, indem der Wafer (100) zuerst abgesenkt wird.

9. Verfahren zur Trennung und zum Lift-out von Proben nach Anspruch 1, **dadurch gekennzeichnet, dass** der Halter ein TEM-Gitter (200) ist.

10. Verfahren zur Trennung und zum Lift-out von Proben nach Anspruch 1, **dadurch gekennzeichnet, dass** die Sonde (120) durch Metallabscheidung mittels Ionenstrahl (210, 230) am Halter (200) befestigt ist.

11. Verfahren zur Trennung und zum Lift-out von Proben nach Anspruch 1, **dadurch gekennzeichnet, dass** die Sonde (120) durch Schneiden mittels Ionenstrahl (160) von der Probe (140) gelöst wird.

12. Verfahren zur Trennung und zum Lift-out von Proben nach Anspruch 1, **dadurch gekennzeichnet, dass** der Wafer (100) eine Halbleitervorrichtung ist.

13. Verfahren zur Trennung und zum Lift-out von Proben nach Anspruch 1, **dadurch gekennzeichnet, dass** der Wafer (100) eine mikromechanische Vorrichtung ist.

14. Verfahren zur Trennung und zum Lift-out von Proben nach Anspruch 1, **dadurch gekennzeichnet, dass** die Wirkungen des Ionenstrahls (160) durch Gasätzen unterstützt werden.

15. Verfahren zur Trennung und zum Lift-out von Proben nach Anspruch 1, **dadurch gekennzeichnet, dass** die Spitze der Sonde (120) durch Metallabscheidung mittels Ionenstrahl am Wafer (100) befestigt ist,
der Ionenstrahl (160) in einem Winkel von ca. 50 Grad zur Ebene des Wafers (100) und durch die folgenden Schritte positioniert wird:
Schneiden eines U-förmigen Pfads auf der Oberfläche des Wafers (100) mit dem Ionenstrahl (160), wobei der Pfad das Target (110) und die befestigte Sonde (120) dergestalt umgibt, dass die Probe (140) vollständig aus dem Wafer (100) freigegeben wird,
leichtes Absenken des Wafers (100),
Bewegen der Sonde (120) mit der Probe (140) an ihr befestigt an ein TEM-Gitter (200), wobei das TEM-Gitter (200) einen querlaufenden Schnitt zur Bereitstellung einer oben offenen V-Form aufweist,
Befestigen der Probe (140) am TEM-Gitter (200) durch Metallabscheidung mittels Ionenstrahl, und
Lösen der Sonde (120) von der Probe (140) durch Schneiden mittels Ionenstrahl (160).

## Revendications

1. Procédé de séparation et de retrait d'échantillons comprenant les étapes consistant à :
a. positionner une tranche (100), laquelle tranche (100) ayant une cible (110), à l'intérieur d'un instrument à faisceau ionique focalisé (FIB), en vue d'une inspection de la cible (110).
b. fixer l'embout de la sonde (120) à la tranche (100),
c. positionner un faisceau d'ions (160) à un angle (α) de moins de 90 degrés par rapport au plan de la tranche (100),
d. couper (150) avec le faisceau d'ions (160) positionné audit angle (α), un échantillon (140) de la tranche (100) en renfermant la cible (110) et la sonde fixée (120), de sorte que l'échantillon (140) est complètement retiré de la tranche (100).
e. déplacer la sonde (120) avec l'échantillon (140) fixé à la sonde sur un support (200) en vue d'une inspection,
f. fixer l'échantillon (140) au support (200), et
g. détacher la sonde (120) de l'échantillon (140),
**caractérisé en ce que** la tranche (100) est d'abord clivée de manière à placer la cible (110) à proximité du bord (115) de la tranche clivée (100).

2. Procédé de séparation et de retrait d'échantillons selon la revendication 1, **caractérisé en ce que** l'embout de la sonde est fixé à la tranche (100) par un procédé de dépôt de métal assisté par faisceau d'ions (130).

3. Procédé de séparation et de retrait d'échantillons selon la revendication 1, **caractérisé en ce que** l'embout de la sonde est fixé à la tranche (100) par attraction électrostatique.

4. Procédé de séparation et de retrait d'échantillons selon la revendication 1, **caractérisé en ce que** l'embout de la sonde est fixé à la tranche (100) avec un adhésif.

5. Procédé de séparation et de retrait d'échantillons selon la revendication 1, **caractérisé en ce que** l'angle (α) du faisceau d'ions (160) par rapport au plan de la tranche (100) est d'approximativement 50 degrés.

6. Procédé de séparation et de retrait d'échantillons selon la revendication 1, **caractérisé en ce que** la coupe avec le faisceau d'ions (160) suit un passage rectangulaire sur la surface de la tranche (100), le passage entourant la cible (110) et la sonde fixée (120).

7. Procédé de séparation et de retrait d'échantillons selon la revendication 1, **caractérisé en ce que** la coupe avec le faisceau d'ions (160) suit un passage en forme de U sur la surface de la tranche (100), le passage entourant la cible (110) et la sonde fixée (120).

8. Procédé de séparation et de retrait d'échantillons selon la revendication 1, **caractérisé en ce que** le retrait de l'échantillon (160) de la tranche (100) est assisté par l'abaissement préalable de la tranche (100).

9. Procédé de séparation et de retrait d'échantillons selon la revendication 1, **caractérisé en ce que** le support est une grille de microscopie électronique par transmission (TEM) (200).

10. Procédé de séparation et de retrait d'échantillons selon la revendication 1, **caractérisé en ce que** la sonde (120) est fixée au support (200) par un procédé de dépôt de métal assisté par faisceau d'ions (210, 230).

11. Procédé de séparation et de retrait d'échantillons selon la revendication 1, **caractérisé en ce que** la sonde (120) est détachée de l'échantillon (140) en coupant avec le faisceau d'ions (160).

12. Procédé de séparation et de retrait d'échantillons selon la revendication 1, **caractérisé en ce que** la tranche (100) est un dispositif à semiconducteurs.

13. Procédé de séparation et de retrait d'échantillons selon la revendication 1, **caractérisé en ce que** la tranche (100) est un dispositif micromécanique.

14. Procédé de séparation et de retrait d'échantillons selon la revendication 1, **caractérisé en ce que** les effets du faisceau d'ions (160) sont assistés par un procédé de gravure par apport de gaz.

15. Procédé de séparation et de retrait d'échantillons selon la revendication 1, **caractérisé en ce que** l'embout de la sonde (120) est fixé à la tranche (100) par un procédé de dépôt de métal assisté par faisceau d'ions.
le faisceau d'ions (160) est positionné à un angle d'environ 50 degrés par rapport au plan de la tranche (100) et par les étapes consistant à
couper avec le faisceau d'ions (160) un passage en forme de U sur la surface de la tranche (100), le passage entourant la cible (110) et la sonde fixée (120) de sorte que l'échantillon (140) est complètement retiré de la tranche (100),
abaisser légèrement la tranche (100).
déplacer la sonde (120) avec l'échantillon (140) fixé à la sonde jusqu'à une grille TEM (200), la grille TEM (200) ayant une découpe à travers elle pour obtenir une ouverture en forme de V sur le dessus,
fixer l'échantillon (140) à la grille TEM (200) par un procédé de dépôt de métal assisté par un faisceau d'ions, et,
détacher la sonde (120) de l'échantillon (140) en coupant avec le faisceau d'ions (160).
